(19) Europäisches Patentamt / European Patent Office / Office européen des brevets

(11) **EP 4 231 800 A1**

(12) **EUROPÄISCHE PATENTANMELDUNG**

(43) Veröffentlichungstag:
    23.08.2023   Patentblatt 2023/34

(21) Anmeldenummer: 22158022.8

(22) Anmeldetag: **22.02.2022**

(51) Internationale Patentklassifikation (IPC):
    **H05K 13/08** (2006.01)

(52) Gemeinsame Patentklassifikation (CPC):
    **H05K 13/085**

(84) Benannte Vertragsstaaten:
    **AL AT BE BG CH CY CZ DE DK EE ES FI FR GB GR HR HU IE IS IT LI LT LU LV MC MK MT NL NO PL PT RO RS SE SI SK SM TR**
    Benannte Erstreckungsstaaten:
    **BA ME**
    Benannte Validierungsstaaten:
    **KH MA MD TN**

(71) Anmelder: **Siemens Aktiengesellschaft**
    **80333 München (DE)**

(72) Erfinder:
    • **Pfaffinger, Alexander**
      **81739 München (DE)**
    • **Royer, Christian**
      **85521 Ottobrunn (DE)**

(74) Vertreter: **Siemens Patent Attorneys**
    **Postfach 22 16 34**
    **80506 München (DE)**

(54) **COMPUTER-IMPLEMENTIERTES VERFAHREN ZUR BESTIMMUNG EINER TEIL-MENGE VON BAUGRUPPENTYPEN EINER VORGEGEBENEN MENGE VON BAU-GRUPPENTYPEN UND EINER ZUGEHÖRIGEN MODIFIZIERTEN FESTRÜSTUNG**

(57)    Die Erfindung beansprucht ein Computer-implementiertes Verfahren zur Bestimmung einer Teilmenge von Baugruppentypen einer vorgegebenen Menge von Baugruppentypen (122) und einer zugehörigen modifizierten Festrüstung, wobei die Baugruppen (120) der Baugruppentypen der Teilmenge nur teilweise mit Bauelementen einer vorgegebenen Menge von Bauelementtypen (160) bestückt werden können, wobei die Bauelemente (155) dieser Bauelementtypen, deren Bauelemente auf einer vorgegebenen Menge von an einer Bestückungslinie (110) anbringbaren Wechseltischen (140) über einen vorgegebenen Zeitraum fest gerüstet sind, eine vorgegebene Festrüstung bilden, aufweisend folgende Schritte:

- Auswählen wenigstens eines Wechseltisches aus der vorgegebenen Menge der Wechseltische;
- Bestimmen der Teilmenge von Baugruppentypen aus der vorgegebenen Menge von Baugruppentypen;
- Ermitteln einer Menge von aussortierbaren Bauelementtypen, die auf dem wenigstens einen ausgewählten Wechseltisch gerüstet sind und die für die Bestückung der bestimmten Teilmenge der Baugruppentypen überflüssig sind;
- Ermitteln einer Menge von notwendigen Bauelementtypen, die sich aus der vorgegebenen Menge der Bauelementtypen abzüglich der Menge der aussortierbaren Bauelementtypen ergibt;
- Ermitteln einer Menge von zusätzlichen Bauelementtypen, die zusammen mit der Menge der notwendigen Bauelementtypen für eine vollständige Bestückung der Baugruppen der bestimmten Baugruppentypen benötigt werden;

- Bestimmen einer modifizierten Festrüstung derart, dass die aussortierbaren Bauelementtypen durch die zusätzlichen Bauelementtypen ausgetauscht werden;
- Ausgeben der bestimmten Teilmenge der Baugruppentypen und der bestimmten modifizierten Festrüstung in einer geeigneten Form zur Steuerung und/oder zur Regelung einer vollständigen Bestückung der Baugruppen der bestimmten Baugruppentypen.

FIG 1

**Beschreibung**

Computer-implementiertes Verfahren zur Bestimmung einer Teilmenge von Baugruppentypen einer vorgegebenen Menge von Baugruppentypen und einer zugehörigen modifizierten Festrüstung

Die Erfindung betrifft ein Computer-implementiertes Verfahren zur Bestimmung einer Teilmenge von Baugruppentypen einer vorgegebenen Menge von Baugruppentypen und einer zugehörigen modifizierten Festrüstung und ein Steuerungssystem sowie ein zugehöriges Computerprogrammprodukt.

Insbesondere im Bereich der Elektronikproduktion werden zu fertigende Leiterplatten bzw. Baugruppen auf SMT-Bestückungslinien durch Oberflächenmontage (SMT = surface mounted technology) hergestellt. Die Elektronikproduktion bzw. -fertigung ist geprägt durch hohe Anforderungen an kurze Durchlaufzeiten, hohe Produktivität (u.a. kurze Umrüstzeiten, kurze Produktionszeiten, usw.) und hohe Flexibilität.

Mehrere Bestückungsautomaten, die üblicherweise durch ein Transportsystem verbunden sind, und die z.B. zum Fertigen bzw. Bestücken von (Elektronik-)baugruppen zusammenwirken, stellen eine Bestückungslinie dar.

In den industriellen Fertigungswerken im Bereich der Elektronikproduktion werden zu fertigende Baugruppen (bzw. Leiterplatten) in Aufträgen mit fest vorgegebenen Losgrößen produziert.

Durch die Losgrößen wird implizit festgelegt, wie häufig ein Baugruppentyp zu produzieren ist. Je kleiner die Losgröße eines Baugruppentyps ist, umso häufiger müssen Baugruppen diesen Baugruppentyps produziert werden und umso größer sind die Rüstaufwände.

Die Erstellung einer (Bauelement-)Rüstung, auch Setup genannt, für eine Bestückungslinie verursacht einen enormen Aufwand. Die Rüstungen der Rüstfamilien werden zur Produktion aufgerüstet und nachher wieder abgerüstet. Das Auslagern und manuelle Aufrüsten von Förderer auf die Wechseltische in einem Vorrüstbereich benötigt für alle Wechseltische einer Rüstfamilie ca. 6-10 Stunden Die Produktion der Baugruppen erfolgt somit in Rüstfamilien. Eine Rüstfamilie ist dabei eine Menge von Baugruppentypen, die mit einer Rüstung auf der Bestückungslinie produzierbar sind.

Mit anderen Worten ausgedrückt umfasst eine Rüstfamilie, auch Cluster genannt, eine Menge von Losen, die innerhalb einer Rüstung gefertigt werden kann. Alle Baugruppen der Baugruppentypen einer Rüstfamilie können also nacheinander ohne Umrüsten auf der Bestückungslinie gefertigt werden.

Eine Rüstung kann auf einem oder mehreren Wechseltischen gehalten werden, die leicht am Bestückungsautomaten ausgewechselt werden können. Ein Aufrüsten eines Wechseltischs mit Bauelementen von vorbestimmten Bauelementtypen ist jedoch - wie oben erläutert - aufwändig. Die Rüstungen werden daher oft in Festrüstungen und Variantenrüstungen unterschieden, wobei eine Festrüstung auf einen oder mehreren Wechseltischen dazu vorgesehen ist, seine Zusammensetzung von Bauelementtypen über einen vorgegebenen Zeitraum, auch als Planungshorizont bezeichnet, zu behalten, während eine Variantenrüstung voraussichtlich innerhalb des Planungshorizonts umgerüstet wird.

Aus EP 2 893 791 B1 ist ein Verfahren zur Bestimmung einer möglichst vorteilhaften Festrüstung für eine Bestückungslinie bekannt.

Variable Fertigungen sind im High-Mix-Low-Volume Bereich sehr gefragt, d.h. sehr viele unterschiedliche Baugruppentypen sind mit geringer Stückzahl zu fertigen. In diesem Bereich werden die Fertigungen, wenn möglich, auch gemischt betrieben, d.h. ein Teil der Produkte wird mit Festrüstung gefertigt und der andere Teil mit Variantenrüstungen. Auf Grund der beschriebenen Vorteile der Festrüstungsfertigung ist es das Ziel dieser Fertigungswerke den Anteil des Produktionsvolumens/Auftragszahlen im Festrüstungsanteil möglichst zu maximieren.

Umgekehrt können nicht beliebig viele Wechseltische mit festgerüsteten Förderern zur Bildung von Festrüstungen eingesetzt werden, da dadurch sehr hohe Kapitalbindungskosten entstehen (ca. 50.000 Euro pro Wechseltisch). Außerdem ist oftmals kein Platz in der Fertigungshalle für sehr viele Festrüstungen vorhanden. Daher werden pro Bestückungslinie typischerweise nur 1 - 3 Festrüstungen geplant.

Oftmals ist es aber so, dass der Anteil der Baugruppentypen, die mit Festrüstungen gefertigt werden, und damit das abgedeckte Produktionsvolumen durch Einsatz einzelner weniger zusätzlicher festgerüsteter Wechseltische signifikant erhöht werden kann. Hat man beispielsweise an einer Bestückungslinie bisher genau eine Festrüstungs-Rüstfamilie gegeben, so kommt es häufig in der Praxis vor, dass ein erheblicher Teil der bisher nicht in der Festrüstungs-Rüstfamilie enthaltenen Baugruppentypen einen hohen Bauelementüberlapp zu den in der Festrüstung gerüsteten Bauelementtypen aufweist, jedoch nicht vollständig mit der vorhandenen Festrüstung gefertigt werden können.

Die Aufgabe der Erfindung besteht darin, ein Verfahren sowie zugehörige Vorrichtung/System bzw. Anordnung anzugeben, bei dem für eine zu bestimmende Menge von Baugruppentypen, die nicht vollständig, d.h. nur teilweise mit einer vorgegebenen Festrüstung gefertigt werden können, eine modifizierte bzw. abgewandelte Festrüstung gefunden wird, um eine möglichst maximierte Gesamtproduktionszeit bei der Bestückung/Fertigung mit Festrüstungen zu erzielen.

Diese Aufgabe wird durch die unabhängigen Ansprüche gelöst. Vorteilhafte Weiterbildungen sind Gegenstand der abhängigen Ansprüche.

Die Erfindung beansprucht ein Computer-implementiertes Verfahren zur Bestimmung einer Teilmenge von Baugruppentypen einer vorgegebenen Menge von Baugruppentypen und einer zugehörigen modifizierten Festrüstung, wobei die Baugruppen der Baugruppentypen der Teilmenge nur teilweise mit Bauelementen einer vorgegebenen Menge von Bauelementtypen bestückt werden können, wobei die Bauelemente dieser Bauelementtypen, deren Bauelemente auf einer vorgegebenen Menge von an einer Bestückungslinie anbringbaren Wechseltischen über einen vorgegebenen Zeitraum fest gerüstet sind/werden, eine vorgegebene Festrüstung bilden,

aufweisend folgende Schritte:

- Auswählen wenigstens eines Wechseltisches aus der vorgegebenen Menge der Wechseltische;
- Bestimmen der Teilmenge von Baugruppentypen aus der vorgegebenen Menge von Baugruppentypen;
- Ermitteln einer Menge von aussortierbaren Bauelementtypen, die auf dem wenigstens einen ausgewählten Wechseltisch gerüstet sind und die für die Bestückung der bestimmten Teilmenge der Baugruppentypen überflüssig (d.h. nicht notwendig, nicht benötigt werden) sind;
- Ermitteln einer Menge von notwendigen Bauelementtypen, die sich aus der vorgegebenen Menge der Bauelementtypen abzüglich der Menge der aussortierbaren Bauelementtypen ergibt;
- Ermitteln einer Menge von zusätzlichen Bauelementtypen, die zusammen mit der Menge der notwendigen Bauelementtypen für eine vollständige Bestückung der Baugruppen der bestimmten Baugruppentypen benötigt werden;
- Bestimmen einer modifizierten Festrüstung derart, dass die aussortierbaren Bauelementtypen durch die zusätzlichen Bauelementtypen (vollständig oder teilweise) ausgetauscht werden;
- Ausgeben der bestimmten Teilmenge der Baugruppentypen und der bestimmten modifizierten Festrüstung in einer geeigneten Form zur Steuerung und/oder zur Regelung einer vollständigen Bestückung der Baugruppen der bestimmten Baugruppentypen.

Eine Festrüstung wird - wie eingangs bereits erwähnt - durch Bereitstellen von Vorräten von Bauelementen der von ihr umfassten Bauelementtypen auf einem oder mehreren Wechseltischen gebildet. Einer eingangs erwähnten Festrüstungs-Rüstfamilie wird eine Festrüstung zugewiesen.

Ein (Bestückungs-)auftrag umfasst eine Stückzahl bzw. Menge von Baugruppen eines Baugruppentyps.

Dabei soll die bestimmte Teilmenge der Baugruppentypen derart optimiert werden, dass eine Kennzahl optimiert, insbesondere maximiert, wird. Die Kennzahl kann die Summe über die Produktionszeiten aller Baugruppentypen der Teilmenge ausdrücken. Sie kann auch eine Anzahl an Bestückungsaufträgen mit den Baugruppentypen aus der Teilmenge oder auch eine Kombination aus beiden Anzahlen mit gegebenenfalls einer Gewichtung der beiden Anzahlen repräsentieren.

In einer Weiterbildung der Erfindung soll eine Menge von Baugruppentypen Produktionszeit-optimal für eine Bestückungslinien bestimmt bzw. ermittelt werden. Es können die aussortierbaren durch die zusätzlichen Bauelementtypen durch Abrüsten der Bauelemente der aussortierbaren Bauelementtypen und durch Aufrüsten der Bauelemente der zusätzlichen Bauelementtypen auf dem wenigstens einen ausgewählten Wechseltisch ausgetauscht werden. So können auf dem wenigstens einen ausgewählten Wechseltisch beispielsweise nur einzelne Spuren an den Wechseltischen genommen werden, um die Bauelemente der aussortierbaren Bauelementtypen aus diesen Spuren zu entnehmen bzw. abzurüsten und an den freigewordenen Plätzen bzw.

Spuren Bauelemente der benötigten zusätzlichen Bauelementtypen aufzurüsten.

In der Praxis wird der Tausch ganzer festgerüsteter Wechseltische bevorzugt. Die Baugruppentypen aus der Teilmenge und die übrigen Baugruppentypen aus der vorgegebenen Menge benötigten für ihre Bestückung in der Regel ein gemeinsames Bauelementspektrum. Das gemeinsame Bauelementspektrum kann gemäß einer Ausführungsform der Erfindung durch Tausch zumindest eines Wechseltisches aus der Festrüstung durch zumindest einen anderen Wechseltisch komplett abgedeckt wird. So kann der zumindest eine andere Wechseltisch zusätzlich festgerüstet bzw. fest vorgerüstet bereitgestellt werden. Dadurch entsteht eine sogenannte modifizierte Festrüstung. Müssen nun Baugruppen aus der der modifizierten Festrüstung gefertigt werden, so genügt der schnelle Austausch des zumindest einen Wechseltisches, um sofort weiterproduzieren zu können.

Die Erfindung bringt somit den Vorteil mit sich, dass die Flexibilität in der Produktion der Baugruppen und der Produkte erhöht wird, in denen die gefertigten Baugruppen eingesetzt werden sollen.

In einer Ausführungsform der Erfindung werden die aussortierbaren durch die zusätzlichen Bauelementtypen dadurch ausgetauscht, dass an der Bestückungslinie der wenigstens eine Wechseltisch mit wenigstens einem anderen Wechseltisch ausgetauscht wird, der mit Bauelementen der zusätzlichen Bauelementtypen und mit Bauelementen der gleichen notwendigen Bauelementtypen, die auf dem wenigstens einen ausgewählten Wechseltisches gerüstet sind, vorgerüstet ist.

In einer Ausführungsform der Erfindung werden die aussortierbaren durch die zusätzlichen Bauelementtypen dadurch ausgetauscht, dass an der Bestückungslinie der wenigstens eine Wechseltisches mit wenigstens einem anderen Wechseltisch ausgetauscht wird, der nur mit Bauelementen der zusätzlichen Bauelementtypen vorgerüstet ist.

Die die Anzahl der aussortierbaren Bauelementtypen und/oder die Anzahl der zusätzlichen Bauelementtypen sollen jeweils einen vorgegebenen Grenzwert unterschreiten.

Das obige Verfahren kann beliebig oft iteriert werden.

Das erfindungsgemäße Verfahren und dessen Weiterbildungen/Ausführungsformen können zentral auf einem Steuerungssystem vorzugsweise der nachstehend beschriebenen Art ausgeführt werden.

Die zur Steuerung bzw. zur Regelung einer vollständigen Bestückung der Baugruppen der bestimmten Baugruppentypen und der damit verbundenen, zur Steuerung der Bestückung dieser Baugruppen geeignete Form ist vorzugsweise computerlesbar. Mit der Steuerung bzw. Regelung der Bestückung der Baugruppen, die entsprechenden Baugruppentypen zugeordnet sind, wird die Bestückung der Baugruppen schließlich ausgeführt.

Anhand der bestimmten Teilmenge der Baugruppentypen und der bestimmten modifizierten Festrüstung in genannter Form kann die Bestückung von Baugruppen gesteuert und/oder geregelt und/oder zur Ausführung gebracht werden.

Beim obigen computer-implementierten Verfahren kann unter "erfasst" bzw. "erfassbar" bzw. "vorgegeben" bzw. "vorgebbar" verstanden werden, dass ein oder mehrere Eingabewerte bereits, beispielsweise durch Standard(werte), festgelegt sind oder von einem Benutzer und/oder durch Ausgabewerte eines vorgeschalteten computerimplementierten Verfahrens vorgegeben bzw. festgelegt werden und/oder vorgebbar bzw. festlegbar sind. Damit werden diese Eingabewerte vom computerimplementierten Verfahren erfasst.

In einer besonders bevorzugten Ausführungsform erfolgt die Durchführung des Verfahrens mittels Gemischt Ganzzahliger Programmierung. Die Gemischt Ganzzahlige Programmierung stellt einen globalen Optimierungsansatz dar, der leicht erweiterbar ist und für die kommerzielle Lösungsverfahren bzw. Lösungsvorrichtungen, auch Solver genannt, erhältlich sind. Mittels Gemischt Ganzzahliger Programmierung können in einer Vielzahl möglicher Lösungen globale Maxima gefunden werden, so dass eine besonders gute Lösung gefunden werden kann. Erhältliche Verfahren bzw. Vorrichtungen zur Gemischt Ganzzahligen Programmierung werden laufend verbessert, sodass zu erwarten ist, dass zukünftig noch bessere Optimierungsergebnisse erzielbar sein werden.

Es kann ein Maß vorbestimmt sein bzw. werden, das einen Anteil an einem Unterschied zwischen der Kennzahl und einer maximal erreichbaren Zuordnungsgüte ausdrückt. Dieser Unterschied wird auch "Gap" genannt. Es wird bevorzugt, ein Optimierungsverfahren zu verwenden, bei dem dieser "Gap" bestimmt werden kann. Das kann insbesondere mit der Gemischt Ganzzahlige Programmierung erreicht werden.

Aus der erfindungsgemäßen Bestimmung der Teilmenge der Baugruppentypen und der zugehörigen modifizierten Festrüstung resultiert eine Produktivitätssteigerung in einem Fertigungswerk, indem

- Rüstaufwand deutlich reduziert wird
- die Produktivität durch kürzere Durchlaufzeiten, kürzere Umrüstzeiten und Produktionszeiten erhöht wird.
- Flexibilität, Durchsatz, Liefertreue werden erhöht
- Niedrigere Losgrößen möglich sind.

Ein weiterer Aspekt der Erfindung sieht ein Steuerungssystem umfassend mindestens eine Recheneinheit, die dazu konfiguriert ist, ein computerimplementiertes Verfahren zur Bestimmung einer Teilmenge von Baugruppentypen einer vorgegebenen Menge von Baugruppentypen und einer zugehörigen modifizierten Festrüstung nach der oben genannten Art und dessen Weiterbildungen/Ausführungsformen auszuführen.

Es kann das erfindungsgemäße Steuerungssystem zentral für mehrere Bestückungslinien geben. Es können eine oder mehrere Steuerungsvorrichtungen, die dann jeweils für die einzelnen Bestückungslinien zuständig sind, mit dem Steuerungssystem verbunden sein. Das Steuerungssystem kann auch abgesetzt von der Steuerungsvorrichtung/den Steuerungsvorrichtungen und gegebenenfalls außerhalb des Fertigungswerks in einem Rechenzentrum bzw. in einer Cloud (Rechnerwolke) angeordnet sein. Es ist auch möglich, dass je ein Steuerungssystem für mehrere Bestückungslinien bzw. ein Steuerungssystem pro Bestückungslinie vorgesehen ist. Bei der zuletzt genannten dezentralen Lösung kommunizieren die mehreren Steuerungssysteme entsprechend untereinander über ein drahtgebundenes und/oder drahtloses Kommunikationsnetzwerk.

Das System bzw. die Vorrichtung und ggf. dazugehörige Einheit(en) sind dazu eingerichtet, solche Verfahrensschritte auszuführen, und können hardware-, firmware- und/oder softwaremäßig implementiert sein.

Ein weiterer Aspekt der Erfindung ist ein Computerprogramm(-produkt) umfassend einen durch eine Recheneinheit bzw. Prozessor ausführbaren Programmkode oder mehrere durch mehrere Recheneinheiten ausführbare und zusammenwirkende Programmkodemodule, welches oder welche Befehle aufweisen, die, die Ausführung des Verfahrens nach, einer der oben genannten Ausführungsformen auf dem Steuerungssystem der oben genannten Art veranlassen.

Das Computerprogramm bzw. -produkt kann auf einem computerlesbaren Speichermedium bzw. Datenträger gespeichert sein. Es ist möglich, dass das Computerprogramm(-produkt) in ein Datenträgersignal eingebunden ist, das für ein Herunterladen desselben von einem Server auf ein Speichermedium vorgesehen ist. Das Computerprogramm bzw. -produkt kann in einer üblichen Programmiersprache (z.B. C++, Java) erstellt sein. Eine Verarbeitungseinrichtung bzw. Prozessor für die Ausführung dessen Programmkodes/Programmkodemodule kann einen marktüblichen Computer oder Server mit entsprechenden Eingabe-, Ausgabe- und Speichermitteln umfassen. Diese Verarbeitungseinrichtung bzw. Recheneinheit kann im Steuerungssystem bzw. - vorrichtung bzw. in deren Einheiten integriert sein.

Das computer-implementierte Verfahren betrifft auch sogenannte Cloud-Dienste (Cloud = Rechnerwolke). Eine Rechnerwolke um fasst in der Regel ein oder mehrere Server, die von einem Cloud-Diensterbringers betrieben werden und dazu eingerichtet sind, einen Cloud-Dienst an einen Dienstnehmer z.B. einem Werkverbund zu liefern. Demnach kann das System in einer Rechnerwolke realisiert sein.

Das Steuerungssystem bzw. die Steuerungsvorrichtungen sowie das Computerprogramm(-produkt) und Datenträger bzw. Datenträgersignal können analog zum oben genannten Verfahren und dessen Weiterbildungen weiter- bzw. ausgebildet sein.

Weitere Vorteile, Einzelheiten und Weiterbildungen der Erfindung ergeben sich aus der nachfolgenden Beschreibung von Ausführungsbeispielen in Verbindung mit den Zeichnungen.

Figur 1 zeigt beispielhaft ein Bestückungssystem, und

Figur 2 zeigt ein Ablaufdiagramm des erfindungsgemäßen Verfahrens.

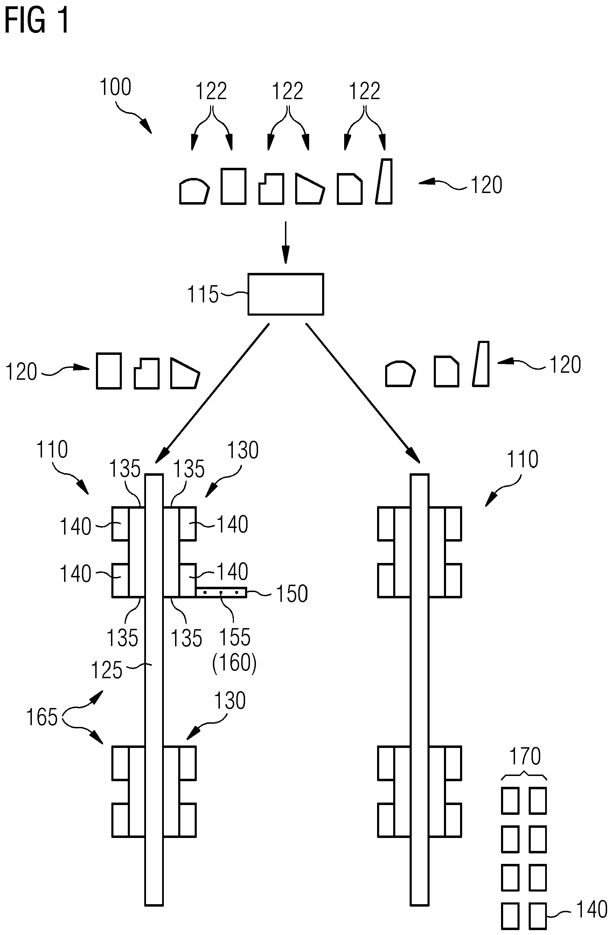

Figur 1 zeigt ein Bestückungssystem 100 mit einer oder mehreren Bestückungslinien. Das Bestückungssystem 100 umfasst eine oder mehrere Bestückungslinien 110 und ein Steuerungssystem 115.

Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Wechseltisch 140 Bauelemente bzw. -teile 155 aufzunehmen und an einer vorbestimmten Position auf der Baugruppe bzw. Leiterplatte 120 zu positionieren, die sich auf dem Transportsystem 125 befindet.

Während des Bestückungsvorgangs steht die Leiterplatte 120 bezüglich des Bestückungsautomaten 130 üblicherweise still. Die Wechseltische 140 umfassen jeweils eine Vielzahl von Förderern bzw. Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementtyps 160 bereit. Für die Bauelemente 155 hat die Zuführungseinrichtung 150 ein Fassungsvermögen, das üblicherweise in Spuren ausgedrückt wird. Eine Spur ist üblicherweise 8 mm breit und die Zahl der Spuren jeder Zuführungseinrichtung 150 ist beschränkt, beispielsweise auf 40. Bauelemente 155 des gleichen Bauelementtyps 160 sind üblicherweise bereitgestellt in einem Gurt, auf einem Tablett oder in einer Röhre. Jeder Bauelementtyp 160 benötigt Platz in der Zuführungseinrichtung 150 mit einer vorbestimmten Anzahl an Spuren, die üblicherweise aneinander angrenzen müssen.

Jede Zuführungseinrichtung 150 kann zur Bereithaltung unterschiedlicher Bauelemente 155 konfiguriert werden und üblicherweise können unterschiedliche Zuführungseinrichtungen 150 an einem Wechseltisch 140 angebracht werden. Wird ein Bauelement 155 eines Bauelementtyps 160 am Bestückungsautomaten 130 benötigt, der nicht in einem der Wechseltische 140 vorhanden ist, so wird üblicherweise nicht einer der angebrachten Wechseltische 140 mit den benötigten Bauelementen 155 versehen, sondern komplett gegen einen anderen, entsprechend bestückten Wechseltisch 140 ausgetauscht. Das Aufrüsten eines einzuwechselnden Wechseltischs 140 mit Bauelementen 155 wird Vorrüstung genannt und kann eine Bearbeitungszeit im Stundenbereich erfordern.

Da ein Wechsel von Wechseltischen 140 an der Bestückungslinie 110 üblicherweise mit einem Produktionsstillstand verbunden ist, wird angestrebt, möglichst seltene Wechsel der Wechseltische 140 durchzuführen.

Ein Bestückungsauftrag umfasst die Stückzahl der zu bestückenden Leiterplatten eines Leiterplattentyps. Zur Bestückung einer anhand der Bestückungsaufträge vorbestimmbaren Menge von Leiterplatten 120 können Rüstungen gebildet sein, die jeweils Vorräte von Bauelementen 155 von vorbestimmten Bauelementtypen 160 umfassen, wobei jede Leiterplatte der Menge der Leiterplatten 120 mit Bauelementen 155 der Rüstung vollständig bestückt werden kann. Eine Rüstung kann realisiert sein durch eine Anzahl an Wechseltischen 140. In der Darstellung von Figur 1 sind eine Festrüstung 165, deren Wechseltische 140 an der Bestückungslinie 110 angebracht sind, und eine Variantenrüstung 170, deren Wechseltische 140 von der Bestückungslinie 110 getrennt sind, gebildet. Es können eine oder mehrere Festrüstungen 165 und eine oder mehrere Variantenrüstungen 170 vorgesehen sein. Ein angestrebter Fall ohne Variantenrüstungen 170 ist möglich.

Die Festrüstung 165 ist dazu eingerichtet, zumindest während eines Planungshorizonts, der beispielsweise ein halbes Jahr oder ein Jahr betragen kann, bezüglich seiner Bauelementtypen 160 unverändert bzw. bestehen zu bleiben. Es können also im Bedarfsfall zwar Bauelemente 155 an den Wechseltischen 140 der Festrüstung 165 nachgefüllt werden, die Zuordnung von Bauelementtypen 160 zu Spuren der Wechseltische 140 bleibt jedoch unverändert. Sind mehrere Festrüstungen 165 vorgesehen, so können diese innerhalb des Planungshorizonts gegeneinander ausgetauscht werden.

Eine Variantenrüstung 170 hingegen ist dazu eingerichtet, während des Planungshorizonts Bauelemente 155 unterschiedlicher Bauelementtypen 160 aufzunehmen, besteht aber nur temporär. Dazu werden üblicherweise die Wechseltische 170, während sie nicht an der Bestückungslinie 110 angebracht sind, von Bauelementen 155 vorbestimmter Bauelementtypen 160 abgerüstet und mit Bauelementen 155 anderer Bauelementtypen 160 aufgerüstet. Diese Umrüstung kann einen erheblichen Anteil manueller Arbeit umfassen und zeitaufwändig sein.

Eine Rüstfamilie, sei es eine Festrüstungs-Rüstfamilie bzw. Variantenrüstungs-Rüstfamilie, ist bestimmt als eine Menge von Leiterplattentypen, deren Leiterplatten auf einer Bestückungslinie bestückt werden können, ohne die Menge der Bauelementtypen zu ändern, die an der Bestückungslinie für die Bestückung bereitgehalten werden. D.h. es muss nicht umgerüstet werden.

Das Steuerungssystem 115 ordnet Leiterplattentypen 122, deren zugeordnete Leiterplatten 120 auf der Bestückungslinie 110 bestückt werden sollen, einer Rüstfamilie zu. Eine Rüstfamilie ist eine Menge von Leiterplattentypen 122, deren Leiterplatten 120 vollständig mit Bauelementen 155 bestückt werden können, die in der zugeordneten Rüstung 165, 170 bereitgestellt sind. Eine Rüstfamilie ist/wird üblicherweise genau einer Rüstung 165, 170 zugeordnet und umgekehrt.

Eine oder mehrere nicht dargestellte Steuerungsvorrichtungen, die jeweils für eine oder mehrere Bestückungslinien 110 die Steuerung-/Regelung des Baugruppenbestückungsprozesses auf den Bestückungslinien zur Erfüllung der Bestückungsaufträge eingerichtet ist/sind, kann/können jeweils mit dem (zentralen) Steuerungssystem 115 in einer Cloud bzw. Rechnerwolke über drahtgebundene und/oder drahtlose Netzwerktechniken verbunden sein.

Das genannte Steuerungssystem 115 ist dazu ausgestaltet, das nachfolgend noch näher erläuterte erfindungsgemäße computer-implementierte Verfahren zur Bestimmung einer Teilmenge von Baugruppentypen einer vorgegebenen Menge von Baugruppentypen und einer zugehörigen modifizierten Festrüstung auszuführen. Das Steuerungssystem kann eine Recheneinheit umfassen, die mit einem nicht dargestelltem Datenspeicher bzw. -medium verbunden sein kann. Aus dem Datenspeicher können gegebenenfalls gespeicherte bzw. vorkonfigurierte Modelle der Bestückungssysteme abgerufen werden. In das Steuerungssystem können zudem eine oder mehrere nicht dargestellte Optimierungseinheiten integriert oder mit dieser gekoppelt sein, in denen sogenannte Solver, z.B. Cplex, Gurobi, eingesetzt werden können. Solver (Löser) sind spezielle mathematische Computerprogramme, die mathematische Probleme numerisch lösen können.

In der Optimierungseinheit kann oder in den Optimierungseinheiten, welche mit der Recheneinheit zusammenspielt/-spielen oder in die Recheneinheit integriert sein können, können (im Multiprocessing) die Auswahl wenigstens eines Wechseltisches aus der vorgegebenen Menge der Wechseltische und die Bestimmung einer Teilmenge von Baugruppentypen einer vorgegebenen Menge von Baugruppentypen sowie einer zugehörigen modifizierten Festrüstung durchgeführt werden. Zudem kann/können die Optimierungseinheit(en) die aussortierbaren Bauelementtypen, die auf dem wenigstens einen ausgewählten Wechseltisch gerüstet sind, die notwendigen und zusätzlichen Bauelementtypen ermitteln, wobei die zusätzlichen Bauelementtypen zusammen mit den notwendigen Bauelementtypen für eine vollständige Bestückung der Baugruppen der bestimmten Baugruppentypen der Teilmenge benötigt werden. Zudem kann/können die Optimierungseinheit(en) eine modifizierten Festrüstung derart bestimmen, dass die aussortierbaren Bauelementtypen durch die zusätzlichen Bauelementtypen ausgetauscht werden.

Im Ausführungsbeispiel kann ein Baugruppentyp beispielsweise insgesamt 200 Bauelementtypen benötigen, von den 190 bereits in der Festrüstung enthalten sind. In der Festrüstung seien insgesamt 400 Bauelementtypen gerüstet. Für die Bestückung dieses Baugruppentyps müssten also lediglich 10 Bauelementtypen aus der Festrüstung aussortiert bzw. abgerüstet werden (welche dafür überflüssig sind bzw. nicht benötigt werden) und an dem freigewordenen Platz die 10 zusätzlich benötigten Bauelementtypen aufgerüstet werden. Es wird dazu wenigstens eine Wechseltisch aus der Festrüstung ausgewählt, auf dem die aussortierbaren Bauelementtypen durch die zusätzlichen ersetzt werden. Bevorzugt wird zumindest ein zweiter anderer Wechseltisch, der mit den zusätzlichen Bauelementtypen und gegebenenfalls mit notwendigen Bauelementtypen vorgerüstet ist, bereitgestellt. In der Festrüstung wird der Austausch der beiden genannten Bauelementtypen durch Austausch des wenigstens einen ausgewählten Wechseltisches mit dem bereitgestellten zweiten Wechseltisch erreicht. Als Ergebnis des Austausches soll eine modifizierte Festrüstung an der Bestückungslinie zur Bestückung der Baugruppen der Baugruppentypen aus der bestimmten Teilmenge zur Verfügung gestellt werden.

Eine nicht dargestellte Ausgabeeinheit des Steuerungssystems liefert die bestimmte Teilmenge von Baugruppentypen und die bestimmte modifizierte Festrüstung in einer zur Steuerung und/oder zur Regelung der Bestückungsauftragserfüllung geeigneten Form. Eine solche Form sollte computerlesebar sein z.B. ein oder mehrere Excellisten in CSV-Format, die die bestimmten einzelnen Baugruppentypen und die aussortierbaren und zusätzlichen Bauelementtypen für den wenigstens einen ausgewählten Wechseltisch und gegebenenfalls die Bauelementtypen zu der vorgegebenen Festrüstung der verbleibenden Wechseltische enthält, wobei gegebenenfalls aus der Information aus dem Datenspeicher entnommen werden kann, welcher Bauelementtyp für welchen Baugruppentyp zu dessen Bestückung geeignet ist.

Anschließend kann bewertet werden, vorzugsweise mittels Simulation, welche Auswirkungen die modifizierte Festrüstung auf den Betrieb der Bestückungslinie haben. Es soll eine Zielfunktion der genannten Optimierung ihr Maximum bzw. eine vorgebbare Kennzahl erreichen.

Gegebenenfalls kann dann die Bestimmung einer Teilmenge von Baugruppentypen einer vorgegebenen Menge von Baugruppentypen und einer zugehörigen modifizierten Festrüstung wiederholt werden.

Diese Excelliste(n) können dann jeweils an ein oder mehrere nicht dargestellte Steuerungsvorrichtungen zu deren Empfang an einer Empfangseinheit gesendet werden. Die nicht dargestellte Steuerungsvorrichtung kann dann die Steuerung und/oder Regelung einer Bestückung von Leiterplatten entsprechend vornehmen.

Zusätzlich und alternativ ist es möglich, dass das Steuerungssystem andere computerlesbare Steuerungssignale aussendet bzw. in Empfang annimmt, um daraus in ihrer Recheneinheit den Steuerungs-/Regelungsprozess zu veranlassen.

Das Bestücken der Baugruppen bzw. Leiterplatten wird üblicherweise so durchgeführt, dass die Bauelemente 155 einzeln mittels Lötpaste an den Leiterplatten 120 fixiert werden. Anschließend können die bestückten Leiterplatten 155 in einem Reflow-Ofen fertig gestellt werden, in dem die Lötpaste vorübergehend aufgeschmolzen wird, sodass die Bauelemente 155 elektrisch und mechanisch mit Leiterbahnen an der Oberfläche der Leiterplatte 120 verbunden werden.

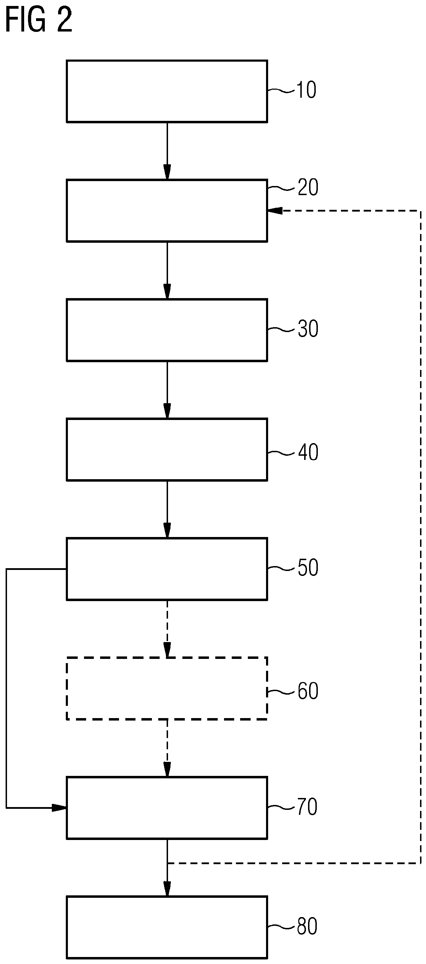

Figur 2 zeigt ein Ablaufdiagramm des erfindungsgemäßen Verfahrens umfassend folgende Schritte:
Im Schritt 10 wird die Menge von Baugruppentypen und die Menge von Bauelementtypen vorgegeben, deren Bauelemente auf einer vorgegebenen Menge von an einer Bestückungslinie anbringbaren Wechseltischen über einen vorgegebenen Zeitraum fest gerüstet sind, eine vorgegebene Festrüstung bilden.

Im nächsten Schritt 20 wird wenigstens eines Wechseltisches aus der vorgegebenen Menge der Wechseltische ausgewählt;

In Schritt 30 wird die Teilmenge von Baugruppentypen aus der vorgegebenen Menge von Baugruppentypen bestimmt, für die in Schritt 50 eine modifizierte Festrüstung bestimmt werden soll.

In Schritt 40 werden folgende Mengen von Bauelementtypen ermittelt:

- eine Menge von aussortierbaren Bauelementtypen, die auf dem wenigstens einen ausgewählten Wechseltisch gerüstet sind und die für die Bestückung der bestimmten Teilmenge der Baugruppentypen überflüssig sind,
- eine Menge von notwendigen Bauelementtypen, die sich aus der vorgegebenen Menge der Bauelementtypen abzüglich der Menge der aussortierbaren Bauelementtypen ergibt, und
- Menge von zusätzlichen Bauelementtypen, die zusammen mit der Menge der notwendigen Bauelementtypen für eine vollständige Bestückung der Baugruppen der bestimmten Baugruppentypen benötigt werden.

In Schritt 50 wird eine modifizierten Festrüstung derart bestimmt, dass die aussortierbaren Bauelementtypen durch die zusätzlichen Bauelementtypen ausgetauscht bzw. ersetzt werden.

Optional Schritt 60: Für Schritt 50 können verschiedene Nebenbedingungen zusätzlich berücksichtigt werden, die beispielsweise in der nachfolgenden Formulierung eines Gemischt ganzzahligen Programms näher beschrieben werden.
Dieser Schritt 60 kann auch übersprungen werden, dann folgt nach Schritt 50 direkt Schritt 70.

Schritt 70: Auf der Basis einer Kennzahl, die im Folgenden berechnet wird, kann die Durchführung der Schritte 20 bis 60 derart optimiert werden, dass ein Optimum, vorzugsweise ein Maximum, dieser Kennzahl erreicht wird. Neben anderen oben im Allgemeinen Teil der vorliegenden Anmeldung genannten Ausführungsformen der Kennzahl, wird die Kennzahl im Ausführungsbeispiel bevorzugt wie folgt berechnet: die Summe über die Produktionszeiten aller Baugruppentypen der Teilmenge wird maximiert.

Optional wird das Verfahren mit Fortfahren mit Schritt 20 wiederholt, um die Kennzahl gegebenenfalls weiter zu optimieren, insbesondere zu maximieren.

Zuletzt wird in Schritt 80 das Ergebnis der bestimmten Teilmenge der Baugruppentypen und der bestimmten modifizierten Festrüstung in einer zur Steuerung und/oder zur Regelung der Bestückungsauftragserfüllung geeigneten (bevorzugt computerlesbaren) Form ausgegeben.

Zur Optimierung der oben beschriebenen Verfahrensschritte können beliebige Optimierungsmethoden verwendet werden, beispielsweise auf der Basis von lokalen Suchverfahren oder metaheuristischen Algorithmen. Bei jedem Durchlauf der genannten Schritte wird die beste bislang bestimmte Zuordnung pseudo-zufällig oder nach einer Heuristik variiert, sodass sich veränderte Zuordnungen ergeben, von denen die mit der optimalen Zuordnungsgüte ausgewählt wird.

Ein Spezialfall von Optimierungsmethoden ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Im Zusammenhang mit MIP (mixed integer programming) bzw. MILP (gemischt ganzzahlige Lineare Programmierung) können für kleine IP-Programme (ganzzahlige Optimierungsmodelle) Standardsolver wie z.B. CPLEX, Scip, Gurobi, Xpress verwendet werden.

Schwieriger als die lineare Optimierung ist der Fall der nichtlinearen ganzzahliger Optimierung (MINLP), bei der die Zielfunktion, die Nebenbedingungen (NB) oder beide vorliegen können. Die Lösung wird erreicht, indem geeignete lineare Approximationen verwendet werden, so dass Standardsolver direkt verwendet werden können. Darüber hinaus können die oben genannten Standardsolver jeweils bestimmte Arten von nichtlinearen Problemen bereits lösen. Außerdem gibt es zusätzliche Solver, die auf die Lösung nichtlinearer Probleme spezialisiert sind (z.B. ANTIGONE, BARON).

Bevorzugterweise erfolgen die Schritte 10 bis 80 durch Lösen eines Gemischt Ganzzahligen Programms.

Optimierer (Solver) auf der Basis Gemischt Ganzzahliger Programmierungen sind - wie oben erläutert - als kommerzielle Produkte erhältlich.

Vorteile der Gemischt ganzzahligen linearen Optimierung (MILP = Mixed Integer Linear Programming) sind:

- Globaler Optimierungsansatz.
- Leicht erweiterbar.
- Sehr gute kommerzielle Standard-Solver (z.B. Gurobi, SCIP, CPLEX, Ilog, Xpress), die in der Praxis weit verbreitet und bewährt sind.
- Für eine ermittelte Lösung ist bekannt, wie weit sie maximal von der optimalen Lösung entfernt ist (Gap).

Im Folgenden wir ein Beispiel für eine MILP-Formulierung zur Bestimmung einer Teilmenge von Baugruppentypen einer vorgegebenen Menge von Baugruppentypen und einer zugehörigen modifizierten Feströstung.

Der erfindungsgemäße Ansatz verfolgt die Bestimmung einer Teilmenge von Baugruppentypen aus einer vorgegebenen Menge von Baugruppentypen für eine gegebene Feströstung einer gegebenen Bestückungslinie, welche durch Auswahl zumindest eines Wechseltisches für einen Austausch von Bauelementtypen geeignet ist. Das MILP (Mixed integer linear programming bzw. gemischt ganzzahliger linearer Programmierung) beschreibt ein Verfahren, das lediglich die Mengen der für die Feströstung bzw. die modifizierte Feströstung benötigten Bauelementtypen betrachtet. In der Praxis benötigt man aber noch die konkrete Rüstung dieser Bauelementtypen, d.h. welche auf welchen Wechseltischen gerüstet werden. Dieser Ansatz kann auf einen oder auf mehrere Tauschtische angewandt werden. Die durch einen Austausch des zumindest einen ausgewählten Wechseltisches mit zumindest einem anderen Wechseltisch modifizierte Feströstung wird so gebildet, dass ein möglichst hohes Produktionsvolumen an Baugruppentypen durch die in der modifizierten Feströstung enthaltenen Baugruppentypen abgedeckt wird. Es ist auch möglich, den ausgewählten Tisch nicht zu tauschen, sondern Bauelementtypen auf Spuren durch andere Bauelementtypen, die für die Bestückung der Baugruppentypen aus der Teilmenge benötigt werden, zu ersetzen bzw. auszutauschen.

In der MILP-Formulierung gelten die folgenden Bezeichnungen.

**Indices**

| | |
|---|---|
| *FC* | Menge der Bauelementtypen in der Feströstung ("fixed comps") |
| NC | Menge der zusätzlichen Bauelementtypen, die nicht in der Feströstung enthalten sind ("new comps") |
| *R* | Menge der möglichen zusätzlichen Baugruppentypen für die modifiziert Feströstung (nicht in der Feströstung enthalten) |
| $R_c$ | Teilmenge der Baugruppentypen aus R, die den Bauelementtyp c *(aus FC oder NC)* benötigen |

**Parameter**

| | |
|---|---|
| $Width_c$ | Platzverbrauch eines Bauelementtyps c in Spuren |
| *TableCap* | Anzahl der Spuren des Wechseltisches |
| *LineCap* | Anzahl der Spuren aller Wechseltische der Bestückungslinie |
| $Time_r$ | Gesamte Produktionszeit des Baugruppentyps r (Anzahl mal Einzelproduktionszeit) |
| MaxAdded | Maximale Anzahl von zusätzlichen Bauelementtypen, die hinzugefügt werden |
| MaxExcluded | Maximale Anzahl der aussortierbaren bzw. abzurüstenden Bauelementtypen |

**Binärvariablen**

| | |
|---|---|
| $assign_r$ | 1, falls Baugruppentyp r in die modifizierte Feströstung aufgenommen wurde (0 sonst). |
| $added_{nc}$ | 1, falls Bauelementtyp nc in der modifizierten Feströstung gerüstet wurde (0 sonst). |
| $excluded_{fc}$ | 1, falls Bauelementtyp fc aus der Feströstung aussortiert bzw. abgerüstet wurde (0 sonst). |

Zielfunktion:

$$Maximiere \sum_{r \in R} assign_r * Time_r$$

Nebenbedingungen:

(1) Die nicht exkludierten (aussortierten) Bauelementtypen müssen auf den restlichen Tischen der Bestückungslinie Platz finden:

$$\sum_{\substack{fc \in \\ FC}} \text{Width}_{fc} \left(1 - excluded_{fc}\right) \leq LineCap - TableCap$$

(2) Die exkludierten Bauelementtypen dürfen höchstens einen Wechseltisch belegen:

$$\sum_{\substack{fc \in \\ FC}} \text{Width}_{fc} \ excluded_{fc} \leq TableCap$$

(3) Die hinzugefügten (added) Bauelementtypen dürfen höchstens einen Wechseltisch belegen:

$$\sum_{\substack{nc \in \\ NC}} \text{Width}_{nc} \ added_{nc} \leq TableCap$$

(4) Alle hinzugefügten Bauelementtypen der Teilmenge der Baugruppentypen aus R müssen in der modifizierten Festrüstung gerüstet sein:

$$\sum_{r \in R_c} \text{assign}_r \ \leq |R_c| added_c \qquad c \in NC$$

(5) Alle aus der Festrüstung übernommenen (nicht exkludierten) Bauelementtypen der Teilmenge der Baugruppentypen aus R müssen in der modifizierten Festrüstung gerüstet sein:

$$\sum_{r \in R_c} \text{assign}_r \ \leq |R_c| \left(1 - excluded_c\right) \quad c \in FC$$

(6) Die Anzahl der zusätzlichen Bauelementtypen, die hinzugefügt werden, ist begrenzt:

$$\sum_{nc \in NC} added_c \leq MaxAdded$$

(7) Die Anzahl der aussortierbaren Bauelementtypen, die exkludiert werden, ist begrenzt:

$$\sum_{fc \in FC} excluded_{fc} \leq MaxExcluded$$

(8) Variablenrestriktionen

$$\text{assign}_r \in \{0,1\} \qquad r \in R$$
$$\text{added}_{nc} \in \{0,1\} \qquad nc \in NC$$
$$\text{excluded}_{fc} \in \{0,1\} \qquad fc \in FC$$

Wird der Schwerpunkt des Verfahrens auf bestmögliche Produktionszeiten für die Festrüstungsbaugruppentypen gelegt, so wird vorteilhafterweise zuerst die Festrüstung erstellt, wodurch für jeden Wechseltisch die Menge der darauf zu liegenden Bauelementtypen definiert ist.

Nun kann ein Wechseltisch ausgewählt werden, der für die Bildung der modifizierten Festrüstung verändert oder gewechselt bzw. getauscht werden soll. Vor Einsatz des MILP wird in dieser Ausführungsform lediglich die Variable excluded = 1 für Baugruppentypen gesetzt, die in der Festrüstung auf dem ausgewählten Tisch zugeordnet wurden, und für die anderen Bauelementtypen excluded = 0. Das MILP findet dann für diesen Wechseltisch den bestmöglichen Wechseltisch, der mit Bauelementtypen für die modifizierte Festrüstung gerüstet wird. Sollen nur einzelne Bauelementtypen/Förderer getauscht werden, so ist im MILP nur excluded = 0 für alle Bauelementtypen der Festrüstung zu setzen, die nicht auf dem ausgewählten Wechseltisch liegen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung der vorstehend beschriebenen Prozesse oder Verfahrensabläufe/-schritte kann anhand von Befehlen bzw. Instruktionen erfolgen, die auf computerlesbaren, nichtflüchtigen Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System z.B. Cloud abzulegen und darauf via Netzwerk zuzugreifen.

Unter "rechner-/computergestützt" bzw. "computerimplementiert" kann im Zusammenhang mit der Erfindung beispielsweise eine Implementierung des Verfahrens verstanden werden, bei dem insbesondere ein Prozessor bzw. eine Recheneinheit, der Teil des Steuerungssystems bzw. der (Steuerungs- bzw. Verarbeitungs-)vorrichtung bzw. -einheit und/oder eines Computers und/oder eines oder mehrerer Dienste in einer Rechnerwolke (Cloud) eines Diensterbringers sein kann, mindestens einen Verfahrensschritt des Verfahrens ausführt.

Sofern es in der nachfolgenden Beschreibung nicht anders angegeben ist, beziehen sich die Begriffe "abbilden", "nachbilden", "empfangen", "anwenden", "ausgeben", "bereitstellen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt oder vorliegen können.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Systemen bzw. Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein. Unter einer "Speichereinheit" kann im Zusammenhang mit der Erfindung beispielsweise ein computerlesbares Speichermedium in Form von Arbeitsspeicher (engl. Random-Access Memory, RAM) oder eine Festplatte verstanden werden.

**Patentansprüche**

**1.** Computer-implementiertes Verfahren zur Bestimmung einer Teilmenge von Baugruppentypen einer vorgegebenen Menge von Baugruppentypen (122) und einer zugehörigen modifizierten Fesrüstung, wobei die Baugruppen (120) der Baugruppentypen der Teilmenge nur teilweise mit Bauelementen einer vorgegebenen Menge von Bauelementtypen (160) bestückt werden können, wobei die Bauelemente (155) dieser Bauelementtypen, deren Bauelemente auf einer vorgegebenen Menge von an einer Bestückungslinie (110) anbringbaren Wechseltischen (140) über einen vorgegebenen Zeitraum fest gerüstet sind, eine vorgegebene Festrüstung bilden,
aufweisend folgende Schritte:

- Auswählen wenigstens eines Wechseltisches aus der vorgegebenen Menge der Wechseltische;
- Bestimmen der Teilmenge von Baugruppentypen aus der vorgegebenen Menge von Baugruppentypen;
- Ermitteln einer Menge von aussortierbaren Bauelementtypen, die auf dem wenigstens einen ausgewählten Wechseltisch gerüstet sind und die für die Bestückung der bestimmten Teilmenge der Baugruppentypen überflüssig sind;
- Ermitteln einer Menge von notwendigen Bauelementtypen, die sich aus der vorgegebenen Menge der Bauelementtypen abzüglich der Menge der aussortierbaren Bauelementtypen ergibt;
- Ermitteln einer Menge von zusätzlichen Bauelementtypen, die zusammen mit der Menge der notwendigen Bauelementtypen für eine vollständige Bestückung der Baugruppen der bestimmten Baugruppentypen benötigt werden;
- Bestimmen einer modifizierten Festrüstung derart, dass die aussortierbaren Bauelementtypen durch die zusätzlichen Bauelementtypen ausgetauscht werden;
- Ausgeben der bestimmten Teilmenge der Baugruppentypen und der bestimmten modifizierten Festrüstung in einer geeigneten Form zur Steuerung und/oder zur Regelung einer vollständigen Bestückung der Baugruppen der bestimmten Baugruppentypen.

2. Verfahren nach dem vorhergehenden Anspruch 1, **dadurch gekennzeichnet, dass** die aussortierbaren durch die zusätzlichen Bauelementtypen durch Abrüsten der Bauelemente der aussortierbaren Bauelementtypen und durch Aufrüsten der Bauelemente der zusätzlichen Bauelementtypen auf dem wenigstens einen ausgewählten Wechseltisch ausgetauscht werden.

3. Verfahren nach Anspruch 1, **dadurch gekennzeichnet, dass** die aussortierbaren durch die zusätzlichen Bauelementtypen dadurch ausgetauscht werden, dass an der Bestückungslinie der wenigstens eine Wechseltisch mit wenigstens einem anderen Wechseltisch ausgetauscht wird, der mit Bauelementen der zusätzlichen Bauelementtypen und mit Bauelementen der gleichen notwendigen Bauelementtypen, die auf dem wenigstens einen ausgewählten Wechseltisches gerüstet sind, vorgerüstet ist.

4. Verfahren nach Anspruch 1, **dadurch gekennzeichnet, dass** die aussortierbaren durch die zusätzlichen Bauelementtypen dadurch ausgetauscht werden, dass an der Bestückungslinie der wenigstens eine Wechseltisches mit wenigstens einem anderen Wechseltisch ausgetauscht wird, der nur mit Bauelementen der zusätzlichen Bauelementtypen vorgerüstet ist.

5. Verfahren nach einem der vorhergehenden Ansprüche, **dadurch gekennzeichnet, dass** die Anzahl der aussortierbaren Bauelementtypen einen vorgegebenen Grenzwert unterschreitet.

6. Verfahren nach einem der vorhergehenden Ansprüche, **dadurch gekennzeichnet, dass** die Anzahl der zusätzlichen Bauelementtypen einen vorgegebenen Grenzwert unterschreitet.

7. Verfahren nach einem der vorhergehenden Ansprüche, **dadurch gekennzeichnet, dass** die bestimmte Teilmenge der Baugruppentypen und die bestimmte zugehörige modifizierte Festrüstung derart optimiert wird, dass eine Kennzahl optimiert, insbesondere maximiert, wird.

8. Verfahren nach dem vorhergehenden Anspruch, **dadurch gekennzeichnet, dass** die Kennzahl die Summe über die Produktionszeiten aller Baugruppentypen der Teilmenge ausdrückt.

9. Verfahren nach dem vorhergehenden Anspruch 7, **dadurch gekennzeichnet, dass** die Kennzahl eine Anzahl an Bestückungsaufträgen mit den Baugruppentypen aus der Teilmenge ausdrückt.

10. Verfahren nach einem der vorhergehenden Ansprüche, **dadurch gekennzeichnet, dass** das Verfahren mittels gemischt ganzzahliger linearer Programmierung durchgeführt wird.

**11.** Steuerungssystem (115) umfassend mindestens eine Recheneinheit, die dazu konfiguriert ist, ein computerimplementiertes Verfahren zur Bestimmung einer Teilmenge von Baugruppentypen einer vorgegebenen Menge von Baugruppentypen (122) und einer zugehörigen modifizierten Festrüstung auszuführen, wobei die Baugruppen (120) der Baugruppentypen der Teilmenge nur teilweise mit Bauelementen einer vorgegebenen Menge von Bauelementtypen (160) bestückt werden können, wobei die Bauelemente (155) dieser Bauelementtypen, deren Bauelemente auf einer vorgegebenen Menge von an einer Bestückungslinie (110) anbringbaren Wechseltischen (140) über einen vorgegebenen Zeitraum fest gerüstet sind, eine vorgegebene Festrüstung bilden,
aufweisend mindestens eine mit der Recheneinheit zusammenwirkende Optimierungseinheit

- zum Auswählen wenigstens eines Wechseltisches aus der vorgegebenen Menge der Wechseltische,
- zum Bestimmen der Teilmenge von Baugruppentypen aus der vorgegebenen Menge von Baugruppentypen,
- zum Ermitteln einer Menge von aussortierbaren Bauelementtypen, die auf dem wenigstens einen ausgewählten Wechseltisch gerüstet sind und die für die Bestückung der bestimmten Teilmenge der Baugruppentypen überflüssig sind,
- zum Ermitteln einer Menge von notwendigen Bauelementtypen, die sich aus der vorgegebenen Menge der Bauelementtypen abzüglich der Menge der aussortierbaren Bauelementtypen ergibt,
- zum Ermitteln einer Menge von zusätzlichen Bauelementtypen, die zusammen mit der Menge der notwendigen Bauelementtypen für eine vollständige Bestückung der Baugruppen der bestimmten Baugruppentypen benötigt werden und
- zum Bestimmen einer modifizierten Festrüstung derart, dass die aussortierbaren Bauelementtypen durch die zusätzlichen Bauelementtypen ausgetauscht werden, und
- eine Ausgabeeinheit zum Ausgeben der bestimmten Teilmenge der Baugruppentypen und der bestimmten modifizierten Festrüstung in einer geeigneten Form zur Steuerung und/oder zur Regelung einer vollständigen Bestückung der Baugruppen der bestimmten Baugruppentypen.

**12.** Computerprogrammprodukt umfassend einen durch eine Recheneinheit ausführbaren Programmkode oder mehrere durch mehrere Recheneinheiten ausführbare und zusammenwirkende Programmkodemodule, welches oder welche Befehle aufweisen, die die Ausführung des Verfahrens nach einem der vorhergehenden Verfahrensansprüche auf dem Steuerungssystem nach Anspruch 11 veranlassen.

**13.** Computerlesbarer Datenträger oder Datenträgersignal umfassend das Computerprogrammprodukt nach dem vorhergehenden Anspruch.

# FIG 1

FIG 2

Europäisches
Patentamt

European
Patent Office

Office européen
des brevets

## EUROPÄISCHER RECHERCHENBERICHT

**Nummer der Anmeldung**

**EP 22 15 8022**

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2010/105876 A1 (SIEMENS AG [DE]; BAUER PETRA [DE] ET AL.) 23. September 2010 (2010-09-23) * Seite 2, Zeile 28 – Seite 16, Zeile 16 * ----- | 1-13 | INV. H05K13/08 |
| X | US 5 170 554 A (DAVIS THOMAS C [US] ET AL) 15. Dezember 1992 (1992-12-15) * Spalte 2, Zeile 49 – Spalte 10, Zeile 17; Abbildungen 1-10 * ----- | 1-9, 11-13 | |
| A | EP 3 930 436 A1 (FUJI CORP [JP]) 29. Dezember 2021 (2021-12-29) * das ganze Dokument * ----- | 1-13 | |

**RECHERCHIERTE SACHGEBIETE (IPC)**

**H05K**

Der vorliegende Recherchenbericht wurde für alle Patentansprüche erstellt

| Recherchenort | Abschlußdatum der Recherche | Prüfer |
|---|---|---|
| **Den Haag** | **12. Juli 2022** | **Kaluza, Andreas** |

EPO FORM 1503 03.82 (P04C03)

ANHANG ZUM EUROPÄISCHEN RECHERCHENBERICHT
ÜBER DIE EUROPÄISCHE PATENTANMELDUNG NR.

EP 22 15 8022

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-07-2022

| Im Recherchenbericht angeführtes Patentdokument | Datum der Veröffentlichung | Mitglied(er) der Patentfamilie | Datum der Veröffentlichung |
|---|---|---|---|
| WO 2010105876 A1 | 23-09-2010 | CN 102356707 A | 15-02-2012 |
| | | DE 102009013353 B3 | 07-10-2010 |
| | | EP 2409556 A1 | 25-01-2012 |
| | | JP 6415465 B2 | 31-10-2018 |
| | | JP 2012520577 A | 06-09-2012 |
| | | JP 2016149545 A | 18-08-2016 |
| | | KR 20110134481 A | 14-12-2011 |
| | | MY 155519 A | 30-10-2015 |
| | | SI 2409556 T1 | 29-08-2014 |
| | | US 2012004762 A1 | 05-01-2012 |
| | | WO 2010105876 A1 | 23-09-2010 |
| US 5170554 A | 15-12-1992 | DE 69120887 T2 | 28-11-1996 |
| | | EP 0478360 A1 | 01-04-1992 |
| | | HK 33297 A | 27-03-1997 |
| | | JP H04246897 A | 02-09-1992 |
| | | KR 930007321 A | 22-04-1993 |
| | | US 5170554 A | 15-12-1992 |
| EP 3930436 A1 | 29-12-2021 | CN 113348736 A | 03-09-2021 |
| | | EP 3930436 A1 | 29-12-2021 |
| | | JP WO2020170305 A1 | 28-10-2021 |
| | | US 2022117126 A1 | 14-04-2022 |
| | | WO 2020170305 A1 | 27-08-2020 |

EPO FORM P0461

Für nähere Einzelheiten zu diesem Anhang : siehe Amtsblatt des Europäischen Patentamts, Nr.12/82

16

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2893791 B1